# EUROPEAN PATENT SPECIFICATION

(11) **EP 3 179 527 B1**
(45) Date of publication and mention of the grant of the patent: **19.02.2020**
(21) Application number: 15198197.4
(22) Date of filing: 07.12.2015
(51) Int. Cl.: H01L 41/047, H01L 41/29

(54) **A TRANDUCER WITH CONNECTORS SOLDERED THEREON**
WANDLER MIT DARAUF GELÖTETEN VERBINDERN
TRANSDUCTEUR AVEC DES CONNECTEURS SOUDÉS SUR CELUI-CI

(43) Date of publication of application: 14.06.2017
(73) Proprietor: Danfoss A/S, 6430 Nordborg (DK)
(72) Inventor: NIELSEN, Søren, 6400 Sønderborg (DK); LYCK, Henrik Christensen, 6400 Sønderborg (DK); CHRISTENSEN, Torben Amby, 6400 Sønderborg (DK)
(74) Representative: Inspicos P/S

(56) References cited:
- WO-A1-2010/035437
- DE-B3-102009 052 814
- US-A- 4 576 670
- US-B1- 6 414 418

## Description

### FIELD OF THE INVENTION

The present invention relates to a transducer comprising a piezoelectric element. The piezoelectric element comprises a first electrode and a second electrode. Connectors are soldered onto the electrodes of the piezoelectric element. The invention further relates to a method for manufacturing the transducer.

### BACKGROUND OF THE INVENTION

Transducers, such as ultrasonic transducers, often comprise an active vibrating element, e.g. in the form of a piezoelectric element. The piezoelectric element is typically enclosed in a housing, which acts as an acoustic window into a medium in which the transducer is supposed to transmit and/or receive pressure waves. Furthermore, the piezoelectric element normally comprises one or more electrode layers applied directly onto one or more surfaces of the piezoelectric element. Electrical contact to the piezoelectric element is obtained by contacting these electrodes, e.g. by means of wires attached to the electrodes. Previously, the contacting process has been performed manually. This is time consuming and provides unreliable electrical contact between the electrodes and the contacting wires.

US 8,136,411 B2 discloses a piezoelectric assembly for an ultrasonic flow meter. A piezoelectric element includes a first face and a second face. A first electrode engages the first face and a second electrode engages the second face. An electrically conductive shim connector is attached to the first electrode, and a first wire is electrically coupled to the shim connector.

DE 10 2009 052 814 B3 discloses an ultrasonic transducer comprising a piezoelectric element with a front side and a back side, each being provided with an electrode. At least one of the electrodes extends along a surface of the piezoelectric element which interconnects the front side and the back side. Electrical connecting elements, in the form of wires, are arranged in contact with the electrodes.

The piezoelectric elements disclosed in US 8,136,411 B2 and DE 10 2009 052 814 B3 are not suitable for automatic manufacture.

### DESCRIPTION OF THE INVENTION

It is an object of embodiments of the invention to provide a transducer which is suitable for being manufactured in an automatic manufacturing process.

It is a further object of embodiments of the invention to provide a transducer in which electrical contact between electrodes and connectors are provided in a reliable manner.

It is an even further object of embodiments of the invention to provide a method for manufacturing a transducer in an automatic manner.

According to a first aspect the invention provides a transducer comprising a piezoelectric element, the piezoelectric element comprising a first electrode arranged on a first surface of the piezoelectric element, a second electrode arranged on a second surface of the piezoelectric element, the second surface being arranged opposite to the first surface, and an intermediate surface interconnecting the first surface and the second surface,
wherein the first electrode extends along at least a part of the intermediate surface, towards the second surface, and/or the second electrode extends along at least a part of the intermediate surface, towards the first surface,
the transducer further comprising a first spade connector soldered onto a portion of the first electrode, the first spade connector having a first free connector end, and a second spade connector soldered onto a portion of the second electrode, the second spade connector having a second free connector end, the first free connector end and the second free connector end being arranged on the same side of the piezoelectric element.

Thus, according to the first aspect, the invention relates to a transducer comprising a piezoelectric element. In the present context the term 'transducer' should be interpreted to mean a device which is adapted to convert a signal in one form of energy into a signal in another form of energy. For instance, an ultrasonic transducer is adapted to convert sound waves into electrical signals. Thereby an ultrasonic transducer may, e.g. be used for ultrasonic flow measurements, ultrasonic energy meters, etc.

In the present context the term 'piezoelectric element' should be interpreted to mean an element which is capable of accumulating electric charge in response to mechanical stress applied to the element. Thus, a piezoelectric element forming a part of an ultrasonic transducer is capable of accumulating electric charge in response to sound waves propagating in a medium in which the ultrasonic transducer is arranged.

The piezoelectric element comprises a first electrode arranged on a first surface of the piezoelectric element and a second electrode arranged on a second surface of the piezoelectric element. The second surface is arranged opposite to the first surface. Accordingly, the first electrode and the second electrode are also arranged opposite to each other. For instance, the first surface and the second surface may extend substantially parallel to each other, in which case the first surface and the second surface will be arranged with a distance there between, which does not vary along the surfaces.

The piezoelectric element further comprises an intermediate surface interconnecting the first surface and the second surface. For instance, the piezoelectric element may have a disc-like shape, in which case the first and second surfaces form flat, opposite sides of the disc, and the intermediate surface forms a cylindrically shaped surface arranged between the flat, opposite sides of the disc.

The first electrode extends along at least a part of the intermediate surface, towards the second surface, and/or the second electrode extends along at least a part of the intermediate surface, towards the first surface. Thus, the first electrode may extend from the first surface onto a part of the intermediate surface, while the second electrode is only arranged on the second surface. As an alternative, the second electrode may extend from the second surface onto a part of the intermediate surface, while the first electrode is only arranged on the first surface. As another alternative, the first electrode as well as the second electrode may extend onto the intermediate surface. The electrode(s) may extend entirely to the rim of the opposite surface, or even onto a portion of the opposite surface. Alternatively, the electrode(s) may only extend a part of the way from the surface carrying the electrode to the opposite surface.

When at least one of the electrodes extends onto the intermediate surface, it is easier to contact both of the electrodes, and to transfer electrical signals from both electrodes in the same direction away from the piezoelectric element, towards a signal processing unit or the like.

A first spade connector is soldered onto a portion of the first electrode and a second spade connector is soldered onto a portion of the second electrode. In the present context the term 'spade connector' should be interpreted to mean a connector which is rigid and shape preserving. It is an advantage that the electrical connections to the electrodes are established by means of spade connectors being soldered onto the electrodes. The soldering technique provides a good electrical connection between the electrodes and the spade connectors. Since the spade connectors are rigid and shape preserving, they can simply be positioned adjacent to the electrodes, and they will remain in this position while the soldering is performed, without any further support. This allows the soldering step to be performed completely automatically, and the transducer can thereby be manufactured in a cost effective and reliable manner, considerably reducing the risk of faulty connections between the electrodes and the connectors. Furthermore, spade connectors can easily be fed to an automatic production line, e.g. using tape 'n reel, bulk feeders, etc., thereby making the transducer of the present invention very suitable for being manufactured in an automatic manufacturing process.

The first/second spade connector is soldered onto a portion of the first/second electrode which is arranged on the first/second surface, onto a portion of the first/second electrode which extends along the intermediate surface, or even onto a portion of the first/second electrode which extends onto the second/first surface.

The first spade connector has a first free connector end and the second spade connector has a second free connector end. The first free connector end and the second free connector end are arranged on the same side of the piezoelectric element. In the present context the term 'free connector end' should be interpreted to mean an end of the spade connector which is arranged opposite to an end which is attached to an electrode of the piezoelectric element. The free connector ends of the spade connectors will typically be connected to a signal processing unit or the like. It is an advantage that the first free connector end and the second free connector end are arranged on the same side of the piezoelectric element, because this makes it easy to connect both of the free connector ends to a signal processing unit or the like arranged on that side of the piezoelectric element.

As described above, the first electrode as well as the second electrode may extend along at least a part of the intermediate surface. According to this embodiment, the first spade connector as well as the second spade connector may be soldered onto a portion of their respective electrodes which extends along the intermediate surface.

The first electrode may extend onto the second surface and/or the second electrode may extend onto the first surface. For instance, the first electrode may only be arranged on the first surface, while the second electrode may extend from the second surface, via the intermediate surface, and onto a portion of the first surface. Thereby the first spade connector as well as the second spade connector may be soldered onto a portion of the respective electrodes which is arranged on the first surface. This makes it very convenient to connect both of the electrodes to the same signal processing unit or the like, via the spade connectors.

Thus, the first spade connector is soldered onto a portion of the first electrode which is arranged on the first surface, and the second spade connector may be soldered onto a portion of the second electrode which is arranged along the intermediate surface and/or onto a portion of the second electrode which is arranged on the first surface.

The first spade connector and/or the second spade connector may be soldered onto a portion of the first/second electrode which is arranged along the intermediate surface. As described above, this embodiment also makes it convenient to connect both of the electrodes to the same signal processing unit or the like, via the spade connectors.

The first spade connector and/or the second spade connector are flexible along at least one direction. According to this embodiment, the first spade connector and/or the second spade connector is/are able to absorb small movements of the piezoelectric element and/or the spade connectors, thereby preventing that the electrical contacts established between the electrodes and the spade connectors are broken. Such small movement may, e.g., be the result of expansions and contractions of piezoelectric element and/or the spade connectors, due to temperature variations.

For instance, the first spade connector and/or the second spade connector fare flexible along a direction which is substantially perpendicular to the first surface and/or to the second surface. Often the spade connectors will extend away from the piezoelectric element along a direction which is substantially perpendicular to the first surface and/or to the second surface. Thus, according to this embodiment, the first spade connector and/or the second spade connector is/are flexible along a direction in which it extends between the contact point(s) on the electrode(s) and a signal processing unit or the like. This is an advantage, because it considerably reduces the risk of breaking the electrical connection(s) between the electrode(s) and the spade connector(s), due to small movements of the spade connectors and/or the piezoelectric element, e.g. caused by thermal expansion and contraction.

Flexibility of a spade connector along a direction being substantially perpendicular to the first surface and/or the second surface of the piezoelectric element may, e.g., be obtained by designing the spade connector with an inherent spring capability, e.g. by providing the spade connector with a suitably bent section.

A contact area between the first/second spade connector and the first/second electrode may form a small part of a total surface area of the first/second spade connector. Thereby the thermal load on the first electrode and/or the second electrode introduced during the soldering process is limited to a small part of the total area of the first/second electrode. Furthermore, vibrational loads on the piezoelectric element, introduced by the soldering material are minimised.

Alternatively or additionally, a contact area between the first/second spade connector and the first/second electrode may form a small part of a total surface area of the first/second electrode. This also limits the thermal load on the first electrode and/or the second electrode introduced during the soldering process to a small part of the total area of the first/second electrode.

For instance, a contact area between the first/second spade connector and the first/second electrode may be between 1% and 20% of the total area of the first/second electrode, such as between 1% and 15%, such as between 2% and 10%, such as between 2% and 5%, such as between 3% and 4%.

The first spade connector and/or the second spade connector may be self-supporting.

According to a second aspect the invention provides a method for manufacturing a transducer, the method comprising the steps of:
- providing a piezoelectric element comprising a first surface, a second surface arranged opposite to the first surface, and an intermediate surface interconnecting the first surface and the second surface,
- providing a first electrode on the first surface and a second electrode on the second surface, the first electrode and/or the second electrode further extending along at least a part of the intermediate surface towards the second/first surface,
- positioning a first spade connector adjacent to a portion of the first electrode and a second spade connector adjacent to a portion of the second electrode, the first spade connector having a first free connector end and the second spade connector having a second free connector end, the first free connector end and the second free connector end being arranged on the same side of the piezoelectric element, and
- soldering the first spade connector onto the portion of the first electrode and the second spade connector onto the portion of the second electrode.

It should be noted that a person skilled in the art would readily recognise that any feature described in combination with the first aspect of the invention could also be combined with the second aspect of the invention, and vice versa. For instance, the method according to the second aspect of the invention may be applied for manufacturing a transducer according to the first aspect of the invention. The remarks set forth above are therefore equally applicable here.

According to the method of the second aspect of the invention, a piezoelectric element is initially provided. The piezoelectric element comprises a first surface, a second surface and an intermediate surface, as described above with reference to the first aspect of the invention.

Next, a first electrode is provided on the first surface and a second electrode is provided on the second surface. Furthermore, the first electrode and/or the second electrode extend(s) along at least a part of the intermediate surface towards the second/first surface, as described above with reference to the first aspect of the invention.

Next, a first spade connector is positioned adjacent to a portion of the first electrode and a second spade connector is positioned adjacent to a portion of the second electrode. As described above, the first/second spade connector may be arranged adjacent to a portion of the first/second electrode extending along the first/second surface, adjacent to a portion of the first/second electrode extending along the intermediate surface, or even adjacent to a portion of the first/second electrode extending onto the second/first surface.

As described above, the first spade connector has a first free connector end and the second spade connector has a second free connector end, and the first and second spade connectors are positioned relative to the piezoelectric element in such a manner that the first free connector end and the second free connector end are arranged on the same side of the piezoelectric element.

Finally, the first spade connector is soldered onto the portion of the first electrode and the second spade connector is soldered onto the portion of the second electrode.

Since the connectors are in the form of spade connectors, they will remain in the positions adjacent to the first and second electrodes, without the need for additional support of the connectors, during the soldering step. This allows the soldering step to be performed in a non-manual manner, ensuring stable electrical connections between the electrodes and the spade connectors, and reducing the manufacturing costs.

Thus, at least the soldering step may be performed in an automated manner, thereby providing a cost effective manufacturing method and reliable electrical connections between the electrodes and the spade connectors, of a homogeneous quality.

The method may further comprise the step of providing solder onto the first spade connector and the second spade connector, prior to the step of positioning the first spade connector and the second spade connector. According to this embodiment, the solder is applied directly onto the spade connectors, e.g. during manufacture of the spade connectors. This allows the solder to be applied under controlled conditions, and it is not necessary to control a supply of solder during the soldering process. Furthermore, it is easy to perform the soldering process, thereby making it even more suitable for being automated. For instance, the solder may be applied to the spade connectors as a part of a coating or surface treatment of the spade connectors. Or the solder may form part of an alloy from which the spade connectors are made.

The soldering step may be performed by means of inductive heating. According to this embodiment, only local heating of the piezoelectric element occurs during the soldering process. This reduces the risk of damaging crystals of the piezoelectric element. As an alternative, the soldering step may be performed in any other suitable manner, e.g. by means of an oven, by means of a 'hot bar', by means of a thermode, etc.

The soldering step may comprise dispensing solder onto the spade connectors and/or onto the electrodes. According to this embodiment, the solder is dispensed, preferably automatically and continuously, during the soldering step. Thereby it is ensured that a uniform amount of solder is applied.

### BRIEF DESCRIPTION OF THE DRAWINGS

The invention will now be described in further detail with reference to the accompanying drawings in which
Fig. 1 is a perspective cross sectional view of an ultrasonic flowmeter comprising two transducers according to an embodiment of the invention,
Fig. 2 is a perspective cross sectional view of a transducer according to an embodiment of the invention, and
Figs. 3a-6b are perspective views of piezoelectric elements for use in transducers according to various embodiments of the invention.

### DETAILED DESCRIPTION OF THE DRAWINGS

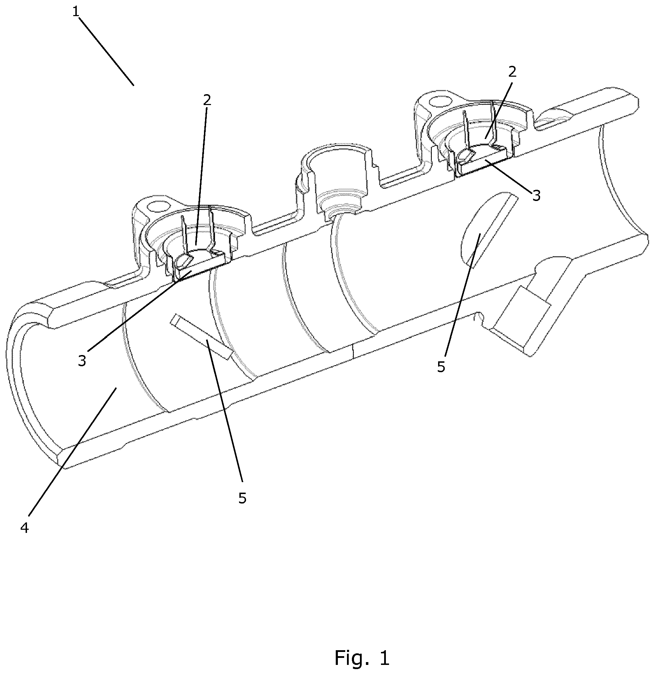

Fig. 1 is a perspective cross sectional view of an ultrasonic flowmeter 1. Two transducers 2 are mounted in an upper part of the ultrasonic flowmeter 1, with one side of a piezoelectric element 3 facing a fluid flowing in a flow channel 4. Two reflectors 5 are further mounted in the flow channel 4. Both of the transducers 2 emit ultrasonic waves, which are reflected by the reflectors 5 and received at the other transducer 2. When propagating from one reflector 5 to the other reflector 5, the ultrasonic waves emitted by one of the transducers 2 propagates in the direction of the fluid flow, and the ultrasonic waves emitted by the other transducer 2 propagates in a direction which is opposite to the direction of the fluid flow. Based on the ultrasonic waves received by the transducers 2, the velocity of the fluid flow can be derived.

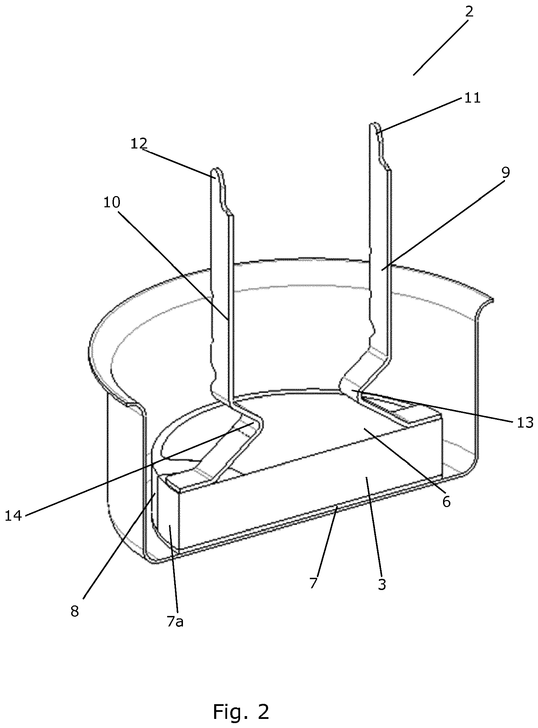

Fig. 2 is a perspective cross sectional view of a transducer 2 according to an embodiment of the invention. The transducer 2 comprises a piezoelectric element 3 having a disc-like shape with a first surface having a first electrode 6 arranged thereon and a second surface having a second electrode 7 arranged thereon. The second surface is arranged opposite to the first surface. The piezoelectric element 3 further comprises an intermediate surface 8 interconnecting the first surface and the second surface. The intermediate surface 8 has a substantially cylindrical shape.

A portion 7a of the second electrode 7 extends along a part of the intermediate surface 8, and further onto the first surface. Thereby a small portion of the second electrode 7 is arranged on the first surface.

A first spade connector 9 is soldered onto a portion of the first electrode 6 which is arranged on the first surface. Furthermore, a second spade connector 10 is soldered onto the portion of the second electrode 7 which is arranged on the first surface. Accordingly, the first spade connector 9 as well as the second spade connector 10 is soldered onto the first surface, but the first electrode 6 as well as the second electrode 7 is contacted by one of the spade connectors 9, 10, i.e. both electrodes 6, 7 are contacted on the same side of the piezoelectric element 3.

The first spade connector 9 comprises a first free connector end 11, and the second spade connector 10 comprises a second free connector end 12. The first free connector end 11 and the second free connector end 12 are arranged on the same side of the piezoelectric element 3. This allows the free connector ends 11, 12 to be easily connected to a signal processing unit or the like.

The first spade connector 9 and the second spade connector 10 are both provided with a bent section 13, 14. The bent sections 13, 14 provide flexibility to the spade connectors 9, 10 along a direction being substantially perpendicular to the first surface of the piezoelectric element 3. Thus, in the case that the spade connectors 9, 10 perform limited movements, e.g. due to thermal expansion and/or contraction of the spade connectors 9, 10, the inherent flexibility of the spade connectors 9, 10 ensures that the electrical connections between the electrodes 6, 7 and the spade connectors 9, 10 are not damaged.

It is an advantage that the connectors establishing an electrical connection between the electrodes 6, 7 and a signal processing device or the like, are in the form of spade connectors 9, 10 being soldered onto the electrodes 6, 7, because the spade connectors 9, 10 are rigid, thereby allowing them to be positioned adjacent to the electrodes 6, 7, and they will remain in this position while being soldered onto the electrodes 6, 7, without requiring additional support. This allows the soldering step to be performed in an automated manner, thereby reducing the manufacturing costs. Furthermore, a uniform quality of the electrical connections between the electrodes 6, 7 and the spade connectors 9, 10 is ensured, when the connectors do not have to be attached manually.

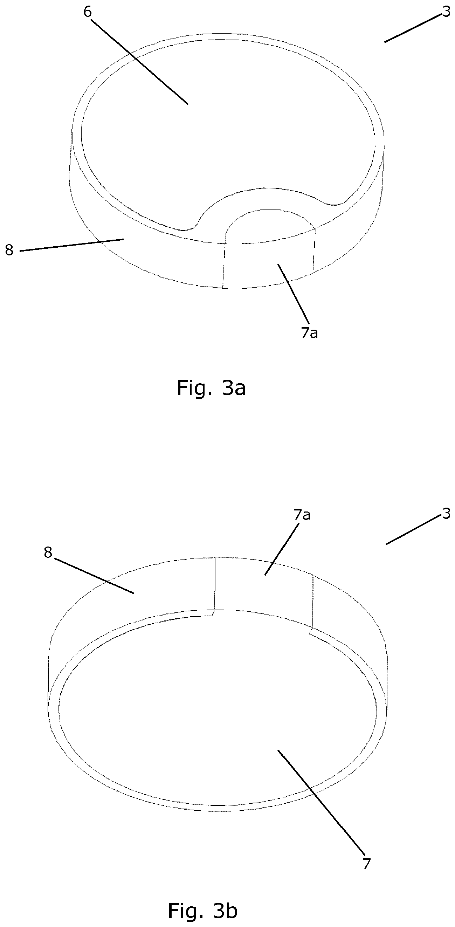

Figs. 3a and 3b are perspective views of a piezoelectric element 3 for use in a transducer according to a first embodiment of the invention, seen from two different angles. The piezoelectric element 3 of Figs. 3a and 3b is identical to the piezoelectric element 3 shown in Fig. 2.

The piezoelectric element 3 comprises a first electrode 6 arranged on a first surface of the piezoelectric element 3, and a second electrode 7 arranged on a second surface of the piezoelectric element 3. An intermediate surface 8 interconnects the first surface and the second surface.

A portion 7a of the second electrode 7 extends along a part of the intermediate surface 8, and further onto a portion of the first surface, as can be seen in Fig. 3a. Accordingly, the first electrode 6 must be contacted at the first surface, while the second electrode 7 may be contacted at the second surface, the intermediate surface 8 or the first surface.

It can be seen in Fig. 3a, that the first electrode 6 is not arranged in the part of the first surface where the portion 7a of the second electrode 7 is arranged, and there is a distance between the first electrode 6 and the second electrode 7 in order to ensure that the electrodes 6, 7 are electrically isolated from each other.

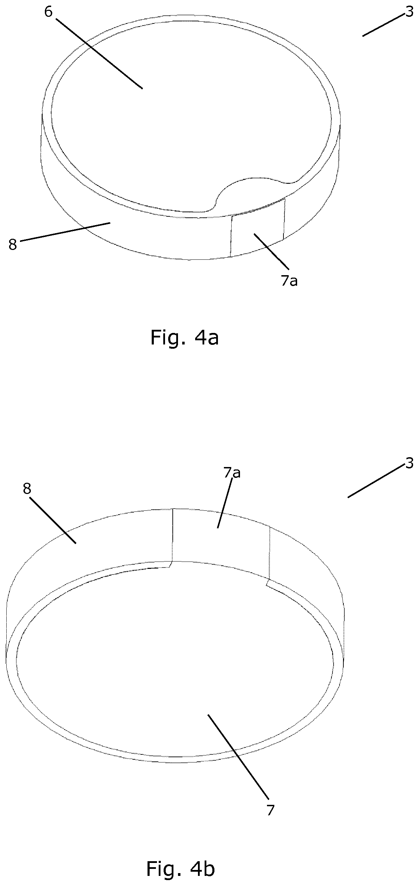

Figs. 4a and 4b are perspective views of a piezoelectric element 3 for use in a transducer according to a second embodiment of the invention, seen from two different angles. The piezoelectric element 3 of Figs. 4a and 4b is very similar to the piezoelectric element 3 of Figs. 3a and 3b, and it will therefore not be described in detail here.

In the piezoelectric element 3 of Figs. 4a and 4b a portion 7a of the second electrode 7 also extends along the intermediate surface 8. However the portion 7a of the second electrode 7 only extends to the edge of the first surface, and not onto the first surface. Accordingly, in this case the second electrode 7 may only be contacted at the second surface or at the intermediate surface 8.

It can be seed from Fig. 4a that the first electrode 6 is not arranged in the part of the first surface immediately adjacent to the position of the portion 7a of the second electrode 7 extending along the intermediate surface 8. This is in order to ensure that the two electrodes 6, 7 are electrically isolated from each other. However, the area of the first electrode 6 shown in Figs. 4a and 4b is larger than the area of the first electrode 6 shown in Figs. 3a and 3b.

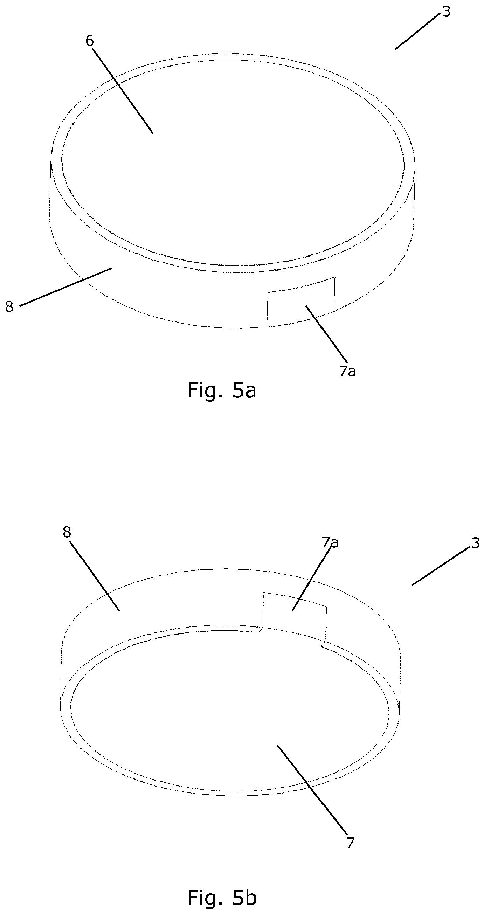

Figs. 5a and 5b are perspective views of a piezoelectric element 3 for use in a transducer according to a third embodiment of the invention, seen from two different angles. The piezoelectric element 3 of Figs. 5a and 5b is very similar to the piezoelectric elements 3 of Figs. 3a-4b, and it will therefore not be described in detail here.

In the piezoelectric element 3 of Figs. 5a and 5b a portion 7a of the second electrode 7 also extends along a part of the intermediate surface 8. However, it only extends part of the way to the first surface, leaving a gap between the end of the portion 7a of the second electrode 7 and the edge of the first surface. This gap ensures the required electrical isolation between the first electrode 6 and the second electrode 7. Thereby the first electrode 6 can be applied to substantially the entire first surface of the piezoelectric element 3, and the area of the first electrode 6 is thereby maximized.

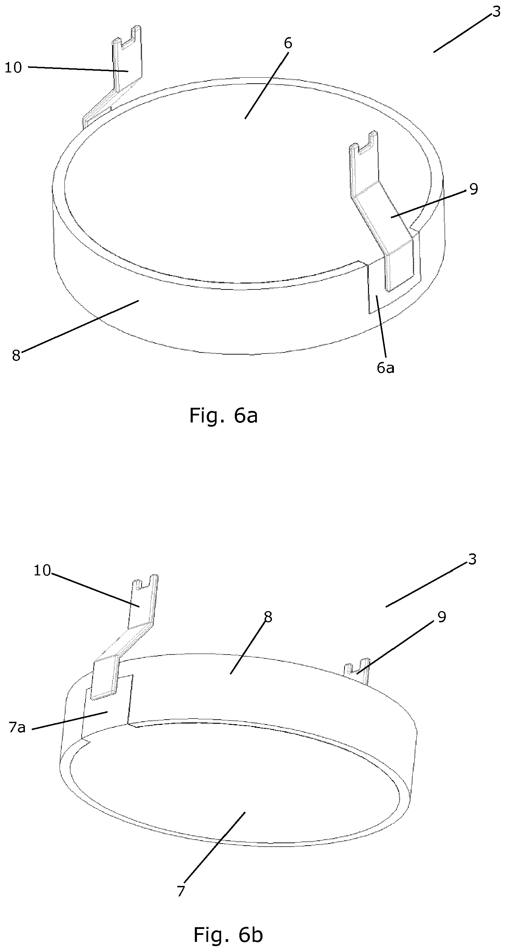

Figs. 6a and 6b are perspective views of a piezoelectric element 3 for use in a transducer according to a fourth embodiment of the invention, seen from two different angles. The piezoelectric element 3 of Figs. 6a and 6b is very similar to the piezoelectric elements 3 of Figs. 3a-5b, and it will therefore not be described in detail here.

In the piezoelectric element 3 of Figs. 6a and 6b a portion 7a of the second electrode 7 extends along a part of the intermediate surface 8, in the same manner as shown in Figs. 5a and 5b, and described above. Furthermore, a portion 6a of the first electrode 6 also extends along a part of the intermediate surface 8.

Accordingly, in the piezoelectric element 3 of Figs. 6a and 6b, the first electrode 6 may be contacted at the first surface or at the intermediate surface 8, and the second electrode 7 may be contacted at the second surface or at the intermediate surface 8.

In Figs. 6a and 6b a first spade connector 9 is soldered onto the portion 6a of the first electrode 6 which extends along the intermediate surface 8. Similarly, a second spade connector 10 is soldered onto the portion 7a of the second electrode 7 which extends along the intermediate surface 8.

## Claims

1. A transducer (2) comprising a piezoelectric element (3), the piezoelectric element (3) comprising a first electrode (6) arranged on a first surface of the piezoelectric element (3), a second electrode (7) arranged on a second surface of the piezoelectric element (3), the second surface being arranged opposite to the first surface, and an intermediate surface (8) interconnecting the first surface and the second surface,
wherein the first electrode (6) extends along at least a part of the intermediate surface (8), towards the second surface, and/or the second electrode (7) extends along at least a part of the intermediate surface (8), towards the first surface,
the transducer (2) further comprising a first rigid and shape preserving spade connector (9) soldered onto a portion of the first electrode (6), the first spade connector (9) having a first free connector end (11), and a second rigid and shape preserving spade connector (10) soldered onto a portion of the second electrode (7), the second spade connector (10) having a second free connector end (12), the first free connector end (11) and the second free connector end (12) being arranged on the same side of the piezoelectric element (3), wherein the spade connectors (9, 10) extend away from the piezoelectric element (3) along a direction which is substantially perpendicular to the first surface and/or the second surface, and wherein the first spade connector (9) and/or the second spade connector (10) is/are flexible along a direction which is substantially perpendicular to the first surface and/or to the second surface.

2. A transducer (2) according to claim 1, wherein the first electrode (6) as well as the second electrode (7) extends along at least a part of the intermediate surface (8).

3. A transducer (2) according to claim 1 or 2, wherein the first electrode (6) extends onto the second surface and/or the second electrode (7) extends onto the first surface.

4. A transducer (2) according to claim 3, wherein the first spade connector (9) is soldered onto a portion of the first electrode (6) which is arranged on the first surface, and wherein the second spade connector (10) is soldered onto a portion (7a) of the second electrode (7) which is arranged along the intermediate surface (8) and/or onto a portion of the second electrode (7) which is arranged on the first surface.

5. A transducer (2) according to any of the preceding claims, wherein the first spade connector (9) and/or the second spade connector (10) is/are soldered onto a portion (6a, 7a) of the first/second electrode (6, 7) which is arranged along the intermediate surface (8).

6. A transducer (2) according to any of the preceding claims, wherein a contact area between the first/second spade connector (9, 10) and the first/second electrode (6, 7) forms a small part of a total surface area of the first/second spade connector (9, 10).

7. A transducer (2) according to any of the preceding claims, wherein a contact area between the first/second spade connector (9, 10) and the first/second electrode (6, 7) forms a small part of a total surface area of the first/second electrode (6, 7).

8. A transducer (2) according to any of the preceding claims, wherein a contact area between the first/second spade connector (9, 10) and the first/second electrode (6, 7) is between 1% and 20% of the total area of the first/second electrode (6, 7).

9. A transducer (2) according to any of the preceding claims, wherein the first spade connector (9) and/or the second spade connector (10) is/are self-supporting.

10. A method for manufacturing a transducer (2), the method comprising the steps of:
- providing a piezoelectric element (3) comprising a first surface, a second surface arranged opposite to the first surface, and an intermediate surface (8) interconnecting the first surface and the second surface,
- providing a first electrode (6) on the first surface and a second electrode (7) on the second surface, the first electrode (6) and/or the second electrode (7) further extending along at least a part of the intermediate surface (8) towards the second/first surface,
- positioning a first rigid and shape preserving spade connector (9) adjacent to a portion of the first electrode (6) and a second rigid and shape preserving spade connector (10) adjacent to a portion of the second electrode (7), the first spade connector (9) having a first free connector end (11) and the second spade connector (10) having a second free connector end (12), the first free connector end (11) and the second free connector end (12) being arranged on the same side of the piezoelectric element (3), wherein the spade connectors (9, 10) extend away from the piezoelectric element (3) along a direction which is substantially perpendicular to the first surface and/or the second surface, and wherein the first spade connector (9) and/or the second spade connector (10) is/are flexible along a direction which is substantially perpendicular to the first surface and/or to the second surface, and
- soldering the first spade connector (9) onto the portion of the first electrode (6) and the second spade connector (10) onto the portion of the second electrode (7).

11. A method according to claim 10, wherein at least the soldering step is performed in an automated manner.

12. A method according to claim 10 or 11, further comprising the step of providing solder onto the first spade connector (9) and the second spade connector (10), prior to the step of positioning the first spade connector (9) and the second spade connector (10).

13. A method according to any of claims 10-12, wherein the soldering step is performed by means of inductive heating.

14. A method according to any of claims 10-13, wherein the soldering step comprises dispensing solder onto the spade connectors (9, 10) and/or onto the electrodes (6, 7).

## Patentansprüche

1. Wandler (2) umfassend ein piezoelektrisches Element (3), wobei das piezoelektrische Element (3) eine erste Elektrode (6), die an einer ersten Fläche des piezoelektrischen Elements (3) angeordnet ist, eine zweite Elektrode (7), die an einer zweiten Fläche des piezoelektrischen Elements (3) angeordnet ist, wobei die zweite Fläche gegenüber der ersten Fläche angeordnet ist, und eine Zwischenfläche (8), die die erste Fläche und die zweite Fläche verbindet, umfasst, wobei sich die erste Elektrode (6) entlang zumindest eines Teils der Zwischenfläche (8), hin zu der zweiten Fläche erstreckt und/oder sich die zweite Elektrode (7) entlang zumindest eines Teils der Zwischenfläche (8), hin zu der ersten Fläche erstreckt,
wobei der Wandler (2) ferner einen ersten steifen und formbeständigen Flachstecker (9), der auf einen Abschnitt der ersten Elektrode (6) gelötet ist, wobei der erste Flachstecker (9) ein erstes freies Steckerende (11) aufweist, und einen zweiten steifen und formbeständigen Flachstecker (10) umfasst, der auf einen Abschnitt der zweiten Elektrode (7) gelötet ist, wobei der zweite Flachstecker (10) ein zweites freies Steckerende (12) aufweist, wobei das erste freie Steckerende (11) und das zweite freie Steckerende (12) an derselben Seite des piezoelektrischen Elements (3) angeordnet sind, wobei sich die Flachstecker (9, 10) weg von dem piezoelektrischen Element (3) entlang einer Richtung erstrecken, die im Wesentlichen im rechten Winkel zu der ersten Fläche und/oder der zweiten Fläche ist, und wobei der erste Flachstecker (9) und/oder der zweite Flachstecker (10) entlang einer Richtung flexibel ist/sind, die im Wesentlichen im rechten Winkel zu der ersten Fläche und/oder zu der zweiten Fläche ist.

2. Wandler (2) nach Anspruch 1, wobei sich die erste Elektrode (6) sowie die zweite Elektrode (7) entlang zumindest eines Teils der Zwischenfläche (8) erstrecken.

3. Wandler (2) nach Anspruch 1 oder 2, wobei sich die erste Elektrode (6) auf die zweite Fläche erstreckt und/oder sich die zweite Elektrode (7) auf die erste Fläche erstreckt.

4. Wandler (2) nach Anspruch 3, wobei der erste Flachstecker (9) auf einen Abschnitt der ersten Elektrode (6) gelötet ist, der an der ersten Fläche angeordnet ist, und wobei der zweite Flachstecker (10) auf einen Abschnitt (7a) der zweiten Elektrode (7), der entlang der Zwischenfläche (8) angeordnet ist, und/oder auf einen Abschnitt der zweiten Elektrode (7), der an der ersten Fläche angeordnet ist, gelötet ist.

5. Wandler (2) nach einem der vorhergehenden Ansprüche, wobei der erste Flachstecker (9) und/oder der zweite Flachstecker (10) auf einen Abschnitt (6a, 7a) der ersten/zweiten Elektrode (6, 7) gelötet ist/sind, der entlang der Zwischenfläche (8) angeordnet ist.

6. Wandler (2) nach einem der vorhergehenden Ansprüche, wobei ein Kontaktbereich zwischen dem ersten/zweiten Flachstecker (9, 10) und der ersten/zweiten Elektrode (6, 7) einen kleinen Teil eines Gesamtflächenbereichs des ersten/zweiten Flachsteckers (9, 10) bildet.

7. Wandler (2) nach einem der vorhergehenden Ansprüche, wobei ein Kontaktbereich zwischen dem ersten/zweiten Flachstecker (9, 10) und der ersten/zweiten Elektrode (6, 7) einen kleinen Teil eines Gesamtflächenbereichs der ersten/zweiten Elektrode (6, 7) bildet.

8. Wandler (2) nach einem der vorhergehenden Ansprüche, wobei ein Kontaktbereich zwischen dem ersten/zweiten Flachstecker (9, 10) und der ersten/zweiten Elektrode (6, 7) zwischen 1 % und 20 % des Gesamtbereichs der ersten/zweiten Elektrode (6, 7) ist.

9. Wandler (2) nach einem der vorhergehenden Ansprüche, wobei der erste Flachstecker (9) und/oder der zweite Flachstecker (10) selbsttragend ist/sind.

10. Verfahren zum Herstellen eines Wandlers (2), wobei das Verfahren folgende Schritte umfasst:
- Bereitstellen eines piezoelektrischen Elements (3), das eine erste Fläche, eine gegenüber der ersten Fläche angeordnete zweite Fläche und eine Zwischenfläche (8), die die erste Fläche und die zweite Fläche verbindet, umfasst,
- Bereitstellen einer ersten Elektrode (6) an der ersten Fläche und einer zweiten Elektrode (7) an der zweiten Fläche, wobei sich die erste Elektrode (6) und/oder die zweite Elektrode (7) ferner entlang zumindest eines Teils der Zwischenfläche (8) hin zu der zweiten/ersten Fläche erstreckt,
- Positionieren eines ersten steifen und formbeständigen Flachsteckers (9) angrenzend an einen Abschnitt der ersten Elektrode (6) und eines zweiten steifen und formbeständigen Flachsteckers (10) angrenzend an einen Abschnitt der zweiten Elektrode (7),
wobei der erste Flachstecker (9) ein erstes freies Steckerende (11) aufweist und der zweite Flachstecker (10) ein zweites freies Steckerende (12) aufweist, wobei das erste freie Steckerende (11) und das zweite freie Steckerende (12) an derselben Seite des piezoelektrischen Elements (3) angeordnet sind, wobei sich die Flachstecker (9, 10) weg von dem piezoelektrischen Element (3) entlang einer Richtung erstrecken, die im Wesentlichen im rechten Winkel zu der ersten Fläche und/oder der zweiten Fläche ist, und wobei der erste Flachstecker (9) und/oder der zweite Flachstecker (10) entlang einer Richtung flexibel ist/sind, die im Wesentlichen im rechten Winkel zu der ersten Fläche und/oder zu der zweiten Fläche ist, und
- Löten des ersten Flachsteckers (9) auf den Abschnitt der ersten Elektrode (6) und des zweiten Flachsteckers (10) auf den Abschnitt der zweiten Elektrode (7).

11. Verfahren nach Anspruch 10, wobei zumindest der Schritt des Lötens auf eine automatisierte Weise durchgeführt wird.

12. Verfahren nach Anspruch 10 oder 11, ferner umfassend den Schritt Bereitstellen von Lötzinn an dem ersten Flachstecker (9) und dem zweiten Flachstecker (10) vor dem Schritt des Positionierens des ersten Flachsteckers (9) und des zweiten Flachsteckers (10).

13. Verfahren nach einem der Ansprüche 10-12, wobei der Schritt des Lötens mittels induktivem Erwärmen durchgeführt wird.

14. Verfahren nach einem der Ansprüche 10-13, wobei der Schritt des Lötens Aufbringen von Lötzinn auf die Flachstecker (9, 10) und/oder auf die Elektroden (6, 7) umfasst.

## Revendications

1. Transducteur (2) comprenant un élément piézoélectrique (3), l'élément piézoélectrique (3) comprenant une première électrode (6) agencée sur une première surface de l'élément piézoélectrique (3), une deuxième électrode (7) agencée sur une deuxième surface de l'élément piézoélectrique (3), la deuxième surface étant agencée en face de la première surface, et une surface intermédiaire (8) interconnectant la première surface et la deuxième surface,
la première électrode (6) s'étendant le long d'au moins une partie de la surface intermédiaire (8) vers la deuxième surface, et/ou la deuxième électrode (7) s'étendant le long d'au moins une partie de la surface intermédiaire (8), vers la première surface,
le transducteur (2) comprenant en outre une première cosse à lame rigide et à maintien de forme (9) brasée sur une portion de la première électrode (6), la première cosse à lame (9) ayant une première extrémité de cosse libre (11), et une deuxième cosse à lame rigide et à maintien de forme (10) brasée sur une portion de la deuxième électrode (7), la deuxième cosse à lame (10) ayant une deuxième extrémité de cosse libre (12), la première extrémité de cosse libre (11) et la deuxième extrémité de cosse libre (12) étant agencées sur le même côté de l'élément piézoélectrique (3), les cosses à lame (9, 10) s'étendant en sens opposé à partir de l'élément piézoélectrique (3) le long d'un sens qui est substantiellement perpendiculaire à la première surface et/ou à la deuxième surface, et la première cosse à lame (9) et/ou la deuxième cosse à lame (10) étant souple (s) le long d'un sens qui est substantiellement perpendiculaire à la première surface et/ou à la deuxième surface.

2. Transducteur (2) selon la revendication 1, dans lequel la première électrode (6) ainsi que la deuxième électrode (7) s'étendent le long d'au moins une partie de la surface intermédiaire (8).

3. Transducteur (2) selon la revendication 1 ou 2, dans lequel la première électrode (6) s'étend sur la deuxième surface et/ou la deuxième électrode (7) s'étend sur la première surface.

4. Transducteur (2) selon la revendication 3, dans lequel la première cosse à lame (9) est brasée sur une portion de la première électrode (6) qui est agencée sur la première surface, et dans lequel la deuxième cosse à lame (10) est brasée sur une portion (7a) de la deuxième électrode (7) qui est agencée le long de la surface intermédiaire (8) et/ou sur une portion de la deuxième électrode (7) qui est agencée sur la première surface.

5. Transducteur (2) selon l'une quelconque des revendications précédentes, dans lequel la première cosse à lame (9) et/ou la deuxième cosse à lame (10) est/sont brasées sur une portion (6a, 7a) de la première/deuxième électrode (6, 7) qui est agencée le long de la surface intermédiaire (8).

6. Transducteur (2) selon l'une quelconque des revendications précédentes, dans lequel une aire de contact entre la première/deuxième cosse à lame (9, 10) et la première/deuxième électrode (6, 7) forme une petite partie d'une superficie totale de la première/deuxième cosse à lame (9, 10).

7. Transducteur (2) selon l'une quelconque des revendications précédentes, dans lequel une aire de contact entre la première/deuxième cosse à lame (9, 10) et la première/deuxième électrode (6, 7) forme une petite partie d'une superficie totale de la première/deuxième électrode (6, 7).

8. Transducteur (2) selon l'une quelconque des revendications précédentes, dans lequel une aire de contact entre la première/deuxième cosse à lame (9, 10) et la première/deuxième électrode (6, 7) se situe entre 1 % et 20 % de la superficie totale de la première/deuxième électrode (6, 7).

9. Transducteur (2) selon l'une quelconque des revendications précédentes, dans lequel la première cosse à lame (9) et/ou la deuxième cosse à lame (10) est/sont auto-portante(s).

10. Procédé de fabrication d'un transducteur (2), le procédé comprenant les étapes de :
- mise à disposition d'un élément piézoélectrique (3) comprenant une première surface, une deuxième surface agencée en face de la première surface, et une surface intermédiaire (8) interconnectant la première surface et la deuxième surface,
- mise à disposition d'une première électrode (6) sur la première surface et une deuxième électrode (7) sur la deuxième surface, la première électrode (6) et/ou la deuxième électrode (7) s'étendant en outre le long d'au moins une partie de la surface intermédiaire (8) vers la deuxième/première surface,
- positionnement d'une première cosse à lame rigide et à maintien de forme (9) adjacente à une portion de la première électrode (6) et une deuxième cosse à lame rigide et à maintien de forme (10) adjacente à une portion de la deuxième électrode (7), la première cosse à lame (9) ayant une première extrémité de cosse libre (11) et la deuxième cosse à lame (10) ayant une deuxième extrémité de cosse libre (12), la première extrémité de cosse libre (11) et la deuxième extrémité de cosse libre (12) étant agencées sur le même côté de l'élément piézoélectrique (3), les cosses à lame (9, 10) s'étendant en sens opposé à partir de l'élément piézoélectrique (3) le long d'un sens qui est substantiellement perpendiculaire à la première surface et/ou à la deuxième surface, et la première cosse à lame (9) et/ou la deuxième cosse à lame (10) étant souple (s) le long d'un sens qui est substantiellement perpendiculaire à la première surface et/ou à la deuxième surface, et
- brasage de la première cosse à lame (9) sur la portion de la première électrode (6) et la deuxième cosse à lame (10) sur la portion de la deuxième électrode (7).

11. Procédé selon la revendication 10, dans lequel au moins l'étape de brasage est réalisée suivant une manière automatisée.

12. Procédé selon la revendication 10 ou 11, comprenant en outre l'étape de mise à disposition d'une matière à braser sur la première cosse à lame (9) et la deuxième cosse à lame (10), avant l'étape de positionnement de la première cosse à lame (9) et de la deuxième cosse à lame (10).

13. Procédé selon l'une quelconque des revendications 10 à 12, dans lequel l'étape de brasage est réalisée au moyen d'un chauffage inductif.

14. Procédé selon l'une quelconque des revendications 10 à 13, dans lequel l'étape de brasage comprend la distribution de la matière à braser sur les cosses à lame (9, 10) et/ou sur les électrodes (6, 7).
